# FASCICULE DE BREVET EUROPEEN

(11) **EP 1 981 315 B1**
(45) Date de publication et mention de la délivrance du brevet: **10.05.2017**
(21) Numéro de dépôt: 08154136.9
(22) Date de dépôt: 07.04.2008
(51) Int. Cl.: H05K 1/02, F21S 8/10

(54) **Support électronique flexible équipé, supportant au moins une diode électroluminescente, et projecteur de véhicule automobile associé**
Ausgerüsteter flexibler elektronischer Träger, der mindestens eine Leuchtdiode umfasst, und entsprechendes Kraftfahrzeugscheinwerfer.
Equipped flexible electronic support, supporting at least one light-emitting diode, and associated motor vehicle headlight.

(30) Priorité: 13.04.2007 FR 0702702
(43) Date de publication de la demande: 15.10.2008
(73) Titulaire: VALEO VISION, 93012 Bobigny (FR)
(72) Inventeur: Biarne, Vincent, 93270, Sevran (FR); Billot, Gérard, 93370, Montfermeil (FR)

(56) Documents cités:
- DE-A1- 10 254 662
- FR-A- 2 881 274
- US-A1- 2004 189 170
- US-A1- 2004 223 327

## Description

La présente invention a pour objet un support électronique équipé supportant au moins une diode électroluminescente, ou LED, et plus particulièrement un support électronique flexible équipé, du type "flexboard" équipé supportant au moins une LED.

On désigne par l'expression "support électronique flexible", également désigné par l'expression circuit imprimé souple, ou encore le terme anglais "flexboard", un ensemble constitué d'un support électriquement isolant, souple et plan - aussi désigné comme support isolant souple - et de conducteurs métalliques plats destinés à assurer des liaisons électriques entre des composants électroniques qui seront disposés à la surface dudit support.

Les circuits imprimés dits classiques ont un support isolant constitué d'une plaque de résine qui présente une certaine flexibilité, au sens où elle peut être courbée ou arquée en exerçant une force de part et d'autre du circuit. Cependant, la déformation de la plaque de résine est limitée à un, voire à deux points d'inflexion, et la courbure ne peut être trop prononcée. De plus, ces plaques sont résilientes et il est difficile de les maintenir dans une configuration déformée.

En revanche, les supports électroniques flexibles, tels que définis dans la présente demande, se distinguent des autres circuits imprimés par le fait qu'au lieu d'une plaque de résine, le support isolant est un support isolant souple, permettant ainsi de conférer au support électronique flexible des orientations et des formes avec quasiment autant de liberté qu'avec un ruban ou une nappe. Ces supports électroniques flexibles peuvent être ainsi facilement adaptés à des configurations tridimensionnelles complexes présentant de nombreux angles ou points d'inflexion. Ce type de support électronique flexible est par exemple utilisé dans le dispositif divulgué par le brevet FR2881274.

On désigne par l'expression "support électronique flexible équipé" un ensemble constitué d'un support électronique flexible, de composants électroniques qui y sont disposés - notamment des diodes électroluminescentes - , et de tout élément accessoire de type radiateur, support de fixation, élément raidisseur...

L'invention a essentiellement pour but de proposer une solution pour équiper une pièce optique tridimensionnelle - par exemple un réflecteur, un écran, un masque, ou toute pièce susceptible de servir de pièce de fixation au sein d'un module projecteur de véhicule automobile - de sources lumineuses de type LEDs, ladite solution étant peu encombrante, et répondant notamment à des contraintes importantes en terme de dissipation de chaleur générée par les LEDs.

Le domaine de l'invention est, d'une façon générale, celui des projecteurs de véhicule automobile. Dans ce domaine, on connaît différents types de projecteurs, parmi lesquels on trouve essentiellement :
- des feux de position, d'intensité et de portée faible ;
- des feux de croisement, ou codes, d'intensité plus forte et de portée sur la route avoisinant 70 mètres ;
- des feux de route longue portée, et des feux de complément de type longue portée, dont la zone de vision sur la route avoisine 200 mètres ;
- des projecteurs perfectionnés, dits bi-fonctions, qui cumulent les fonctions de feux de croisement et de feu de route en incorporant un cache amovible ;
- des feux anti-brouillard ;
- des feux de signalisation ;
- des dispositifs de signalisation à usage diurne, appelés dispositifs projecteurs DRL (pour Daytime Running Light en langue anglaise)....

Pour l'ensemble de ces projecteurs, traditionnellement, on utilise des sources lumineuses de type lampes halogènes, ou lampes à décharge. Mais depuis quelques années, les équipementiers automobiles ont proposé l'utilisation de diodes électroluminescentes ; cette utilisation concernait initialement essentiellement les feux de signalisation ou les feux arrières, mais une augmentation de la puissance disponible au niveau des LEDs permet désormais d'envisager de nouvelles utilisations de ces sources lumineuses, notamment pour réaliser les fonctions lumineuses présentes à l'avant du véhicule, et plus précisément les fonctions DRL et position ou lanternes. Les diodes électroluminescentes permettant la réalisation de ce type de fonction sont désignées comme des LEDs de puissance. Une LED de puissance est, plus généralement, une LED permettant, seule ou en association avec d'autres LEDs, la réalisation de fonctions d'éclairage autres que les fonctions de signalisation et les fonctions associées aux dispositifs de signalisation disposés à l'arrière des véhicules. Une LED de puissance a généralement un flux lumineux de l'ordre d'au moins 30 lumens.

Les diodes électroluminescentes présentent un certain nombre d'avantages :
- tout d'abord, depuis longtemps, on sait que ce type de diodes ne rayonne pas de façon omnidirectionnelle, mais rayonne dans un demi espace opposé à un substrat qui supporte la jonction P-N de la diode considérée ; ainsi, en utilisant un rayonnement plus directif que les lampes halogènes, ou à décharge, de l'état de la technique, la quantité d'énergie perdue est moins importante qu'avec les lampes à décharge ou halogènes ;
- ensuite, on a récemment perfectionné ces diodes en terme d'intensité de puissance de rayonnement. De plus, les diodes fabriquées émettent un rayonnement depuis longtemps dans le rouge, mais désormais également dans le blanc, ce qui accroît le champ de leurs utilisations envisageables. En ce qui concerne les LEDs utilisées dans la signalisation, la quantité de chaleur qu'elles dégagent est relativement limitée, et un certain nombre de contraintes, liées à la dissipation de la chaleur dans les dispositifs projecteurs de l'état de la technique, disparaissent ; la problématique de dissipation de chaleur demeure cependant importante pour les LEDs de puissance ;
- enfin, les diodes consomment moins d'énergie, même à intensité de rayonnement égal, que les lampes à décharge ou les lampes halogènes ; elles sont peu encombrantes, et leur forme particulière offre des possibilités nouvelles pour la réalisation et la disposition des surfaces complexes qui leur sont associées, notamment en les disposant au sur des supports électroniques de type support électronique flexible.

De plus en plus, notamment pour répondre à des critères esthétiques souhaités par les constructeurs automobiles, on cherche à disposer tridimensionnellement, au sein d'un même dispositif projecteur, plusieurs diodes électroluminescentes: au sein d'un dispositif projecteur donné, différentes LEDs, éventuellement de différents types, sont disposées sur des plans de support différents ; en d'autres termes, une pièce optique tridimensionnelle peut désormais être destinée à recevoir et à maintenir une pluralité de sources lumineuses dans des plans différents.

Les solutions existantes pour de telles juxtapositions consistaient initialement, dans le cas des LEDs, essentiellement à utiliser des supports électroniques rigides, connus de l'homme du métier, de type substrats CEM1, FR4, SMI, MCPCB ou autres pour supporter les différentes sources lumineuses. L'utilisation des supports électroniques rigides présente notamment, outre un coût de fabrication élevé, des inconvénients en terme d'interconnexion des différents substrats.

L'utilisation des supports électroniques flexibles est avantageuse du fait de leur caractère souple : on peut les plier aisément pour les placer tridimensionnellement sur une partie optique de forme quelconque. Un autre avantage important des supports électroniques flexibles réside dans le fait qu'ils ne nécessitent aucun système de connectique pour l'interconnexion entre différentes cartes électroniques, permettant une économie de main d'oeuvre, fiabilisant l'ensemble et réduisant l'encombrement par rapport aux solutions faisant intervenir des supports rigides.

Dans l'état de la technique, on a récemment proposé une solution particulière pour réaliser une mise en place de diodes électroluminescentes dans un environnement tridimensionnel. Ainsi le brevet FR2881274, décrit un support électronique flexible équipé de LEDs permettant un assemblage simplifié sur un réflecteur comportant plusieurs plans de support de LEDs. Des éléments radiateurs sont assemblés sur une première face du flexboard. Les LEDs sont fixées sur une deuxième face du flexboard, chaque LED étant positionnée de telle sorte qu'un élément radiateur lui soit directement associé, de part et d'autre du flexboard. Chaque élément radiateur comprend des ouvertures destinées à recevoir un pion de fixation pointant au niveau d'une face arrière du réflecteur. Ceci permet d'assembler de manière simple et précise le flexboard équipé et le réflecteur en introduisant dans chaque ouverture un des pions de fixation du réflecteur.DE 102 54 662 A1 décrit un support de montage de diodes électroluminescentes comprenant au moins une plaque rigide de support qui est relié à l'une de leurs surfaces principales à une carte de circuit imprimé souple et au moins une diode électroluminescente formée sur la carte flexible à circuits imprimées. Cependant l'utilisation actuelle de LEDs de puissance nécessite d'améliorer davantage l'évacuation de la chaleur au niveau des LEDs

Le but de l'invention est donc de trouver un dispositif intégrant un support équipé, qui permette d'évacuer davantage la chaleur émise par des LEDs et notamment des LEDs de puissance.

L'objet de l'invention propose une solution répondant aux contraintes de dissipation thermiques des flexboards équipés de LEDs, notamment de LEDs de puissance, tout en présentant un encombrement minimal. A cet effet, on propose, dans l'invention, d'associer une couche de matériau thermiquement conducteur sur la face du flexboard opposée à la face supportant les diodes électroluminescentes. Par matériau thermiquement conducteur, on désigne ici un matériau présentant un pouvoir de dissipation satisfaisant, suffisant pour évacuer l'ensemble des calories produites par les LEDs.

Avantageusement, dans l'invention, on associe, chaque LED à un élément raidisseur assurant un maintien rigide pour la LED considérée, facilitant les opérations de fabrication du flexboard équipé.

L'invention concerne donc essentiellement support électronique équipé pour projecteur de véhicule automobile, ledit un support électronique équipé comprenant notamment :
- un support isolant souple plan équipé sur une première face d'une pluralité de pistes conductrices plates ;
- au moins une source lumineuse de type diode électroluminescente disposée sur la première face du support isolant souple, et reliée à au moins une des pistes conductrices plates ;
une deuxième face du support isolant souple étant recouverte au moins partiellement par une couche de matériau thermiquement conducteur pour dissiper la chaleur produite par les diodes électroluminescentes, ladite couche comprenant une zone de contact au niveau de la liaison entre la diode et ledit support électronique équipé, et une zone prolongée s'étendant hors de cette zone de contact, la dissipation de la chaleur s'effectuant essentiellement au niveau de cette zone prolongée.

Plus particulièrement, l'invention concerne un support électronique flexible équipé, du type « flexboard » équipé, pour projecteur de véhicule automobile, ledit support électronique équipé comprenant :
- un support isolant souple plan équipé sur une première face d'une pluralité de pistes conductrices plates ;
- au moins une source lumineuse de type diode électroluminescente disposée sur la première face du support isolant souple, et reliée à au moins une des pistes conductrices plates ;
une deuxième face du support isolant souple est recouverte au moins partiellement par une couche de matériau thermiquement conducteur pour dissiper la chaleur produite par ladite diode électroluminescente, la couche comprenant une zone de contact au niveau de la liaison entre ladite diode électroluminescente et le support électronique flexible équipé, et au moins une zone prolongée s'étendant hors de cette zone de contact, la couche de matériau thermiquement conducteur recouvrant au moins partiellement la deuxième face du support isolant souple au niveau de la zone prolongée, la dissipation de la chaleur s'effectuant essentiellement au niveau de cette zone prolongée

Le support électronique flexible équipé selon l'invention peut comporter, en plus des caractéristiques principales qui viennent d'être mentionnées dans le paragraphe précédent, une ou plusieurs caractéristiques supplémentaires parmi les suivantes:
- chaque diode électroluminescente disposée sur la première face du support isolant souple est associée à un élément raidisseur disposé au niveau de la diode à laquelle il est associé sur la deuxième face du support isolant souple ;
- l'élément raidisseur présente au moins une ouverture destinée à recevoir un pion de fixation, ledit pion de fixation appartenant à une partie optique tridimensionnelle sur laquelle est placée le support électronique flexible équipé ;
- les éléments raidisseurs présentent au moins une zone formant saillie ;
- l'ouverture de l'élément raidisseur présente une pluralité de languettes de rétention pour maintenir, après déformation, le pion de fixation qui lui est destiné ;
- une couche d'adhésif à fonction exclusive de tenue est disposée, sur le support isolant souple au niveau de chaque raidisseur, en contact avec chaque raidisseur ;
- la couche de matériau thermiquement conducteur recouvre la majorité, préférentiellement la totalité, de la deuxième face du support isolant souple ;
- l'épaisseur et le matériau constituant la couche de matériau thermiquement conducteur sont choisis de manière à ce que la couche de matériau thermiquement conducteur soit plastique ; le support électronique flexible équipé selon la présente invention est ainsi malléable et on peut lui conférer des formes tridimensionnelles variées, pouvant présenter de nombreux points d'inflexion et des inflexions importantes, par exemple des angles ou des courbures supérieures à 45 degrés. Avec une certaine épaisseur, choisie en fonction du matériau, on peut avoir une déformation manuelle du support électronique flexible équipé selon la forme choisie, avant montage, cette forme étant conservée par le support. Par exemple, on peut utiliser une feuille de cuivre pliable, par exemple d'1 millimètre d'épaisseur ;
- la couche de matériau thermiquement conducteur présente une épaisseur inférieure à 75 microns ;
- au moins deux raidisseurs sont joints venus de matière en une seule pièce, de sorte que la partie métallique située entre les zones de contact des raidisseurs constitue ladite zone prolongée ;
- chaque raidisseur comprend des ailettes pour augmenter la surface de dissipation thermique ;
- l'élément raidisseur et/ou la couche en matériau thermiquement conducteur est/sont en cuivre ;
- les diodes électroluminescentes sont de type diodes électroluminescentes de puissance ;
- le support électronique flexible équipé comprend plusieurs diodes électroluminescentes, et plusieurs zones prolongées s'étendant entre chaque diode électroluminescente.

La présente invention se rapporte également à un projecteur de véhicule automobile comprenant un support électronique équipé selon la présente invention. Préférentiellement le support flexible équipé de ce projecteur a une disposition tridimensionnelle présentant plusieurs points d'inflexions et le support flexible comprend plusieurs diodes électroluminescentes, les points d'inflexions étant situés entre certaines ou l'ensemble des diodes électroluminescentes. Préférentiellement, il y a au moins un point d'inflexion entre chaque diode électroluminescente.

La présente invention se rapporte également à un procédé de fabrication du support électronique flexible équipé selon l'invention comportant au moins les caractéristiques principales, et éventuellement une ou plusieurs des caractéristiques supplémentaires mentionnées, ledit procédé comprenant les différentes étapes consistant à :
- recouvrir d'une pellicule de matériau thermiquement conducteur une deuxième face d'un support isolant plan d'un support électronique flexible, une première face du support isolant étant équipée d'une pluralité de pistes conductrices;
- placer de part et d'autre du support électronique flexible au moins une diode électroluminescente, reliée à au moins une des pistes conductrices, et un élément raidisseur plan associé, l'élément raidisseur présentant une épaisseur comprise entre 0.5 millimètre et cinq millimètres;
- puis réaliser une opération de brasage par refusion pour fixer les diodes électroluminescentes sur le support électronique flexible.

Dans un mode de mise en oeuvre particulier de l'invention, l'étape de placement de l'élément raidisseur comporte l'opération préalable consistant à disposer un adhésif à fonction exclusive de tenue sur la pellicule de matériau thermiquement conducteur au niveau de l'élément raidisseur.

Un autre objet de l'invention réside dans l'utilisation du support électronique flexible équipé selon l'invention, comportant au moins les caractéristiques principales et éventuellement une ou plusieurs des caractéristiques supplémentaires mentionnées, dans un dispositif projecteur de véhicule automobile de type DRL.

Dans les différents modes de réalisation selon la présente invention, le flexboard supporte et connecte la LED électriquement. La couche de matériau conducteur thermique dissipe la chaleur émise par la LED. Préférentiellement, le raidisseur permet de protéger la liaison de la LED sur le flex, d'assurer la précision de son positionnement relatif à l'optique et de fixer l'ensemble LED plus Flex sur l'optique, par agrafage, par un moyen agrippant ou par rivetage au moyen d'ultrasons, ou de tout autre déformation plastique.

L'invention et ses différentes applications seront mieux comprises à la lecture de la description qui suit et à l'examen des figures qui l'accompagnent.

Celles-ci ne sont présentées qu'à titre indicatif et nullement limitatif de l'invention. Les figures montrent :
- à la figure 1, déjà décrite, une représentation schématique d'un exemple de réalisation d'un circuit électronique flexible équipé ;
- à la figure 2, également déjà décrite, une représentation schématique d'une coupe de l'exemple de réalisation de la figure 1 ;
- à la figure 3, une représentation schématique d'un exemple de réalisation d'un circuit électronique flexible équipé selon un mode de réalisation particulièrement avantageux de l'invention;
- à la figure 4, une représentation schématique d'une coupe de l'exemple de réalisation de la figure 3 ;
- à la figure 5, un exemple de moyens de fixation du circuit électronique flexible selon l'invention sur une pièce optique.

Les différents éléments apparaissant sur plusieurs figures auront gardé, sauf précision contraire, la même référence.

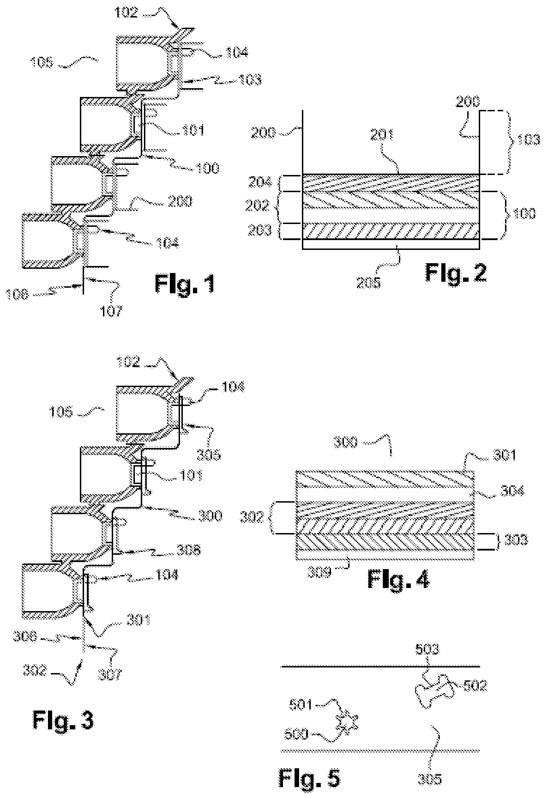

En figure 1, on a représenté de façon schématique une coupe d'un élément optique 105, destiné à être positionné dans un dispositif projecteur, ledit élément optique résultant de la fixation sur un réflecteur 102 d'un support électronique flexible 100, désigné comme flexboard, équipé, sur une première face 106 de diodes électroluminescentes 101 ; le réflecteur 102 constitue un environnement tridimensionnel, dans la mesure où il comporte plusieurs plans de support de sources lumineuses.

Des éléments raidisseurs 103 sont disposés sur une deuxième face 107 du flexboard 100 au niveau de chaque diode électroluminescente ; on constitue ainsi une pluralités de paires diode-raidisseur, les deux éléments desdites paires étant disposés de part et d'autre du flexboard 100 en n'étant séparées que par le support isolant souple constituant, dans cet exemple, le flexboard. En d'autres termes, la position de chaque LED est approximativement centrée sur la position de l'élément raidisseur qui lui est associé. Dans la fabrication de chaque élément raidisseur 103, on prévoit de ménager des ouvertures, parmi lesquelles au moins une première ouverture destinée à recevoir un pion de fixation 104 pointant au niveau d'une face arrière du réflecteur 102 pour assurer la fixation de chaque élément raidisseur 103 sur le flexboard 100.

Comme représenté sur la figure 2, le flexboard 100, ici montré en coupe, est constitué d'un support isolant souple 202 - composé de façon connue de couches de matériaux différents - sur lequel sont disposées des pistes électriquement conductrices 203 recouvertes d'un matériau électriquement isolant 205, doit être complété par une couche d'adhésif 204, destiné à assurer le transfert thermique et le maintien mécanique du raidisseur 103 au niveau de son corps 201. L'adhésif choisi pour la couche 204 doit présenter des caractéristiques de conduction thermique élevées afin de transmettre au mieux la chaleur dégagée par la LED au raidisseur 103.

L'élément raidisseur 103 comporte de part et d'autre de son corps 201 des ailettes 200 de dissipation de la chaleur perpendiculaires au corps 201 du raidisseur en contact avec le flexboard. Il s'agit d'un exemple non limitatif. Les ailettes pourraient par exemple effectuer un autre angle avec le corps de l'élément radiateur. Les éléments radiateurs peuvent être constitués d'une simple plaque métallique, repliée pour constituer les ailettes. D'autres matériaux thermiquement conducteurs sont cependant envisageables. Différentes techniques peuvent également être utilisées pour obtenir les éléments radiateurs à ailettes, telles que des techniques de moulage, d'extrusion, ou d'usinage.

Tel que représenté, le corps 201 de l'élément raidisseur 103 constitue donc la couche de matériau thermiquement conducteur recouvrant la deuxième face du support isolant souple 202, et également la zone de contact au niveau de la liaison entre la LED et ledit support électronique équipé. La chaleur émise par la LED est transmise via cette zone de contact directement aux zones prolongées, constituées par les ailettes 200. La dissipation de la chaleur s'effectue essentiellement au niveau de ces zones prolongées.

Un tel dispositif présente des propriétés de dissipation de la chaleur nettement améliorées par rapport à l'art antérieur, tout en ayant les avantages suivants :
- avantage photométrique du fait que les diodes électroluminescentes sont montées directement sur la pièce optique ; la position de chaque LED par rapport à la partie du réflecteur où elle doit être placée est ainsi plus précise, chaque LED étant associée à un élément raidisseur indépendant ; chaque LED garde ainsi une liberté de mouvement qui permet de la recentrer individuellement, sans provoquer de déplacement pour les autres LEDs ;
- avantage financier du fait de la réduction du nombre de LEDs nécessaires pour obtenir un flux donné, grâce à une optimisation du placement de chacune des LEDs au sein du réflecteur.

Cependant, les éléments raidisseurs 103 sont encombrants, notamment du fait de la présence d'ailettes. Cet encombrement est pénalisant car il se traduit par une augmentation du volume du produit final dans lequel le flexboard va être installé. Outre l'encombrement dans le produit final, la présence des ailettes 200 contraint d'assembler les raidisseurs sur le flexboard après une opération de brasage par refusion du flexboard équipé des LEDs, l'épaisseur des pattes empêchant de placer les raidisseurs sur les plateaux intervenant dans de telles opérations de brasage. Le processus de fabrication du flexboard équipé est ainsi complexifié.

Selon un autre mode de réalisation, non représenté, au moins deux éléments raidisseurs sont réalisés venus de matière. Par exemple, ces deux éléments raidisseurs sont réalisés dans une même plaque de matériau conducteur. Dans un tel cas, la portion de la plaque qui reliera la zone où l'élément raidisseur est en contact avec le flexboard au niveau de la LED, constitue une zone prolongée hors des zones de contact, par laquelle la chaleur est dissipée. On utilise le même type d'adhésif que précédemment évoqué. Selon une variante de réalisation, l'ensemble des éléments raidisseurs est formé d'une seule plaque. Dans un tel cas, il est nécessaire de conférer à la plaque une forme permettant à chaque zone de contact d'entrer en contact avec une LED.

Bien que moins encombrant, un tel système est peu adaptable puisque le support équipé ne présente pas de portion souple entre certaines LEDs. Dans le cas extrême où l'ensemble est formé d'une seule plaque, le support n'est adaptable qu'à un environnement tridimensionnel précis, donc qu'à un projecteur déterminé.

De plus dans les deux modes de réalisation précités l'adhésif thermiquement conducteur utilisé est particulièrement coûteux.

Un mode de réalisation particulièrement avantageux de la présente invention, représenté en figure 3 et 4, permet de palier ces inconvénients.

Dans l'exemple représenté en figure 3, un circuit électronique flexible 300 équipé selon l'invention est mis en place dans un environnement similaire à celui de la figure 1 : on retrouve ainsi sur la figure 3 l'élément optique 105 représenté en coupe, les diodes électroluminescentes 101, le réflecteur 102 et les pions de fixation 104.

La structure de flexboard 300 est détaillée également en référence à la figure 4 dans une vue en coupe. Le flexboard 300 est constitué d'un support isolant souple 302, sur une première face 306 duquel sont disposées des pistes conductrices 303 servant à l'alimentation des LEDs 101. Les pistes conductrices sont recouvertes d'un matériau isolant 309. Une deuxième face 307 du support isolant souple est recouverte par une pellicule 301 de matériau thermiquement conducteur, ou matériau dissipateur de chaleur. Une couche d'adhésif 304 est utilisée dans cet exemple pour maintenir la pellicule 301.

La pellicule 301 peut être réalisée dans tout matériau présentant de bonnes capacités de dissipation de chaleur, par exemple du cuivre, de l'aluminium, de l'inox, ou différents alliages à base de cuivre, mais aussi des matériaux à base de graphite. La pellicule 301 n'est pas réalisée dans un matériau du type adhésif. Pour obtenir une dissipation de chaleur optimale, l'épaisseur de la pellicule 301 est de préférence inférieure à 2 millimètre, avantageusement comprise entre 60 microns et 90 microns, des tests concluants ayant été réalisés avec une épaisseur de 75 microns. Préférentiellement l'épaisseur est inférieure ou égale à 75 microns, et particulièrement entre 60 microns et 75 microns.

La pellicule 301 constitue la couche de matériaux thermiquement conducteurs recouvrant le support isolant souple selon la présente invention. La zone située au niveau de la liaison entre la LED et ledit support électronique équipé constitue la zone de contact. La portion de pellicule qui relie chaque zone de contact, constitue une zone prolongée hors des zones de contact, par laquelle la chaleur est dissipée. La pellicule étant flexible de par son épaisseur et de part le matériau la constituant, le support équipé est donc flexible.

Avantageusement, la pellicule 301 recouvre l'ensemble de la deuxième face 307 du support isolant souple 302 améliorant ainsi grandement la dissipation de la chaleur produite par les LEDs.

Dans un exemple particulier de réalisation, on dispose, du côté de la deuxième face 307 et au-dessus de la pellicule 301, des éléments raidisseurs 305, qui sont constitués d'une plaque rigide, par exemple métallique, et qui sont placés à l'aplomb de chaque diode électroluminescentes 101. Leur fonction est notamment d'assurer la tenue des diodes électroluminescentes lors de leur disposition sur le flexboard 300, mais aussi lors des opérations de montage sur les pièces optiques de type réflecteur.

La présence de la pellicule 301 et sa capacité à dissiper la chaleur produite par les LEDs permet d'utiliser des raidisseurs 305 sans ailettes. L'échange thermique est essentiellement effectué au niveau de la pellicule 301 située entre deux raidisseurs 305. Un gain substantiel en épaisseur du flexboard équipé est ainsi réalisé, comparé au mode de réalisation représenté en figures 1 et 2.

Les éléments raidisseurs 305 sont avantageusement maintenus sur la pellicule 301 par un adhésif présentant exclusivement des propriétés de tenue mécanique ; les éléments raidisseurs 305 ne font en effet pas office de radiateur, et il n'est donc pas nécessaire d'utiliser un adhésif - plus coûteux - présentant de bonnes caractéristiques d'échanges thermiques. L'épaisseur des éléments raidisseurs est de l'ordre de 0.5 à 3 millimètres. Ils peuvent, pour augmenter leur caractère rigide, présenter une zone une zone formant saillie 308, par exemple sous la forme d'un bossage s'étendant selon la totalité d'un côté du raidisseur. Même avec la zone formant saillie, les raidisseurs n'excèdent pas cinq millimètres d'épaisseur.

Dans tous les cas, en présence ou non de raidisseurs, le flexboard équipé selon l'invention peut être totalement équipé avant de subir des opérations de brasage par refusion destiné essentiellement à souder les LEDs sur le flexboard. En effet, aucun élément n'est trop encombrant pour être disposé sur les plaques intervenant dans de telles opérations de brasage par refusion.

Il est à noter que, dans le cas où les contraintes d'encombrement dans le projecteur où doit être monté le support électronique flexible équipé ne sont pas élevées, on peut toujours utiliser un raidisseur avec des ailettes en plus de la pellicule 301, pour augmenter encore davantage le pouvoir de dissipation thermique. Mais la pellicule 301 donnant une dissipation thermique suffisante, on préfère généralement diminuer l'encombrement du support flexible électronique équipé.

Des pions de fixation 104 sont destinés à être introduits dans des ouvertures du raidisseur en traversant le flexboard percé à cet effet.

La figure 5 montre deux exemples d'ouvertures ménagées dans le raidisseur. Ces exemples d'ouverture peuvent être appliqués aux différents raidisseurs des différents modes de réalisation selon la présente invention, notamment ceux représentés en figures 1 et 3. Dans le premier exemple d'ouverture 500 et le deuxième exemple d'ouverture 502, chaque ouverture est destinée à recevoir un pion de fixation 104 pointant au niveau d'une face arrière du réflecteur 102. On peut alors procéder à l'assemblage du flexboard équipé 300 et du réflecteur 102 en introduisant dans chaque ouverture un des pions de fixation 104 du réflecteur 102. Une opération complémentaire de clippage entre le flexboard équipé et le réflecteur peut alors être réalisée afin d'assurer le maintien définitif entre ces deux éléments.

Dans un mode de réalisation avantageux, à savoir le premier exemple, la première ouverture 500 est caractérisée par une forme globalement circulaire, avec un pourtour présentant une pluralité de languettes de rétention 501. Chaque languette de rétention 501 est caractérisée par une base, directement rattachée au raidisseur 305, et par une extrémité libre, orientée vers la partie centrale de la première ouverture 500. Une telle ouverture constitue ainsi un moyen d'agrafage ou un moyen pour agripper. A noter qu'un tel moyen peut également être réalisé par une ouverture présentant une unique languette de rétention 503, comme c'est le cas de la deuxième ouverture 502, dans le deuxième exemple.

Lors de l'introduction d'un des pions de fixation 104 dans les ouvertures 500 et/ou 502, chaque languette de rétention 501 et/ou 503 peut légèrement se déformer dans le sens du mouvement d'introduction, les extrémités libres de chaque languette de rétention accompagnant alors le pion de fixation 104 dans son évolution. La pluralité des languettes de rétention 501 de la première ouverture 500 permet de maintenir au mieux le pion de fixation 104 dans la première ouverture 500 : le caractère élastique du matériau employé pour réaliser le raidisseur, et donc pour réaliser les languettes de rétention 501, présente cet avantage de gêner un mouvement inverse au mouvement d'introduction du pion de fixation 104 dans la première ouverture 500.

La fonction principale de la seconde ouverture 502 est de recevoir un des pions de fixation 104 pour prévenir toute rotation du raidisseur. Dans la pratique, on prévoit que chaque diode électroluminescente est associée à deux pions de fixation 104. Le flexboard 300 présente alors un nombre d'ouvertures égal au double du nombre de LEDs.

Les éléments raidisseurs sont alors de préférence réalisés dans un matériau ductile, par exemple du cuivre. Deux ouvertures par élément raidisseur permettent d'éviter toute rotation desdits raidisseurs lors des opérations de montage des circuits électroniques flexibles équipés selon l'invention.

D'autres procédés de fixation, à base d'ultrasons pour écraser les pions de fixation ou d'opérations de bouterollage sont également utilisables pour maintenir les flexboards équipés selon l'invention sur tout support optique.

## Revendications

1. Support électronique flexible équipé (100; 300), du type « flexboard » équipé, pour projecteur de véhicule automobile, ledit support électronique équipé comprenant :
- un support isolant souple plan (202 ; 302) équipé sur une première face (106 ; 306) d'une pluralité de pistes conductrices (203 ; 303) plates ;
- au moins une source lumineuse de type diode électroluminescente (101) disposée sur la première face du support isolant souple, et reliée à au moins une des pistes conductrices plates ;
**caractérisé en ce qu'**une deuxième face (107 ; 307) du support isolant souple est recouverte au moins partiellement par une couche (201 ; 301) de matériau thermiquement conducteur pour dissiper la chaleur produite par ladite diode électroluminescente, ladite couche comprenant une zone de contact au niveau de la liaison entre ladite diode électroluminescente et ledit support électronique flexible équipé, et au moins une zone prolongée s'étendant hors de cette zone de contact, ladite couche de matériau thermiquement conducteur recouvrant au moins partiellement ladite deuxième face du support isolant souple au niveau de la zone prolongée, la dissipation de la chaleur s'effectuant essentiellement au niveau de cette zone prolongée.

2. Support électronique flexible équipé selon la revendication 1, **caractérisé en ce que** chaque diode électroluminescente (101) disposée sur la première face (106 ; 306) du support isolant souple est associée à un élément raidisseur (103 ; 305) disposé au niveau de la diode à laquelle il est associé sur la deuxième face (107 ; 307) du support isolant souple.

3. Support électronique flexible équipé selon la revendication précédente, **caractérisé en ce que** l'élément raidisseur (103 ; 305) présente au moins une ouverture (500 ; 502) destinée à recevoir un pion de fixation (104), ledit pion de fixation appartenant à une partie optique tridimensionnelle (102) sur laquelle est placée le support électronique flexible équipé.

4. Support électronique flexible équipé selon la revendication précédente, **caractérisé en ce que** l'ouverture de l'élément raidisseur (103 ; 301) présente une pluralité de languettes de rétention (501 ; 503) pour maintenir, après déformation, le pion de fixation (104) qui lui est destiné.

5. Support électronique flexible équipé selon l'une au moins des revendications précédentes, **caractérisé en ce que** la couche de matériau thermiquement conducteur recouvre la majorité, préférentiellement la totalité, de la deuxième face du support isolant souple.

6. Support électronique flexible équipé selon l'une au moins des revendications précédentes, **caractérisé en ce que** l'épaisseur et le matériau constituant la couche de matériau thermiquement conducteur sont choisis de manière à ce que la couche de matériau thermiquement conducteur soit plastique.

7. Support électronique flexible équipé selon l'une au moins des revendications précédentes, **caractérisé en ce que** la couche de matériau thermiquement conducteur présente une épaisseur inférieure à 2 millimètres.

8. Support électronique flexible équipé selon l'une au moins des revendications précédentes, **caractérisé en ce que** la couche de matériau thermiquement conducteur présente une épaisseur inférieure ou égale à environ 75 microns.

9. Support électronique flexible équipé selon l'une au moins des revendications précédentes, **caractérisé en ce que** l'élément raidisseur (103 ; 305) et/ou la couche en matériau thermiquement conducteur (201 ; 301) est/sont en cuivre.

10. Support électronique flexible équipé selon l'une au moins des revendications précédentes, **caractérisé en ce que** les diodes électroluminescentes (101) sont de type diodes électroluminescentes de puissance.

11. Support électronique flexible équipé selon l'une au moins des revendications précédentes, **caractérisé en ce qu'**il comprend plusieurs diodes électroluminescentes (101) et plusieurs zones prolongées s'étendant entre chaque diode électroluminescente.

12. Projecteur de véhicule automobile, **caractérisé en ce qu'**il comprend un support électronique flexible équipé selon l'une quelconque des revendications précédentes.

13. Projecteur de véhicule automobile selon la revendication 12, **caractérisé en ce que** le support flexible équipé a une disposition tridimensionnelle présentant plusieurs points d'inflexions et **en ce que** le support flexible comprend plusieurs diodes électroluminescentes (101), les points d'inflexions étant situés entre certaines ou l'ensemble des diodes électroluminescentes.

## Patentansprüche

1. Bestückter flexibler elektronischer Träger (100; 300) vom Typ bestücktes Flexboard, für Kraftfahrzeugscheinwerfer, wobei der bestückte elektronische Träger umfasst:
- einen ebenen elastischen isolierenden Träger (202; 302), der auf einer ersten Seite (106; 306) mit einer Vielzahl flacher Leiterbahnen (203; 303) bestückt ist;
- wenigstens eine Lichtquelle vom Typ Leuchtdiode (101), die auf der ersten Seite des elastischen isolierenden Trägers angeordnet und mit wenigstens einer der flachen Leiterbahnen verbunden ist;
**dadurch gekennzeichnet, dass** eine zweite Seite (107; 307) des elastischen isolierenden Trägers wenigstens teilweise mit einer Schicht (201; 301) aus thermisch leitendem Material zum Ableiten der von der Leuchtdiode erzeugten Wärme bedeckt ist, wobei die Schicht einen Kontaktbereich in Höhe der Verbindung zwischen der Leuchtdiode und dem bestückten flexiblen elektronischen Träger und wenigstens einen sich außerhalb dieses Kontaktbereichs erstreckenden Verlängerungsbereich aufweist, wobei die Schicht aus thermisch leitendem Material wenigstens teilweise die zweite Seite des elastischen isolierenden Trägers in Höhe des Verlängerungsbereichs bedeckt, wobei die Ableitung der Wärme im Wesentlichen in Höhe des Verlängerungsbereichs erfolgt.

2. Bestückter flexibler elektronischer Träger nach Anspruch 1,
**dadurch gekennzeichnet, dass** jede auf der ersten Seite (106; 306) des elastischen isolierenden Trägers angeordnete Leuchtdiode (101) einem Versteifungselement (103; 305) zugeordnet ist, das auf Höhe der Leuchtdiode angeordnet ist, der es auf der zweiten Seite (107; 307) des elastischen isolierenden Trägers zugeordnet ist.

3. Bestückter flexibler elektronischer Träger nach dem vorhergehenden Anspruch,
**dadurch gekennzeichnet, dass** das Versteifungselement (103; 305) wenigstens eine Öffnung (500; 502) aufweist, die zur Aufnahme eines Befestigungsstifts (104) bestimmt ist, wobei der Befestigungsstift zu einem dreidimensionalen optischen Teil (102) gehört, auf dem der bestückte flexible elektronische Träger platziert ist.

4. Bestückter flexibler elektronischer Träger nach dem vorhergehenden Anspruch,
**dadurch gekennzeichnet, dass** die Öffnung des Versteifungselements (103; 301) eine Vielzahl von Rückhaltezungen (501; 503) aufweist, um nach einer Verformung den dieser zugedachten Befestigungsstift (104) zu halten.

5. Bestückter flexibler elektronischer Träger nach wenigstens einem der vorhergehenden Ansprüche,
**dadurch gekennzeichnet, dass** die Schicht aus thermisch leitendem Material die zweite Seite des elastischen isolierenden Trägers überwiegend, vorzugsweise vollständig bedeckt.

6. Bestückter flexibler elektronischer Träger nach wenigstens einem der vorhergehenden Ansprüche,
**dadurch gekennzeichnet, dass** die Dicke und das die Schicht aus thermisch leitendem Material bildende Material solchermaßen gewählt sind, dass die Schicht aus thermisch leitendem Material plastisch ist.

7. Bestückter flexibler elektronischer Träger nach wenigstens einem der vorhergehenden Ansprüche,
**dadurch gekennzeichnet, dass** die Schicht aus thermisch leitendem Material eine Dicke von weniger als 2 Millimetern aufweist.

8. Bestückter flexibler elektronischer Träger nach wenigstens einem der vorhergehenden Ansprüche,
**dadurch gekennzeichnet, dass** die Schicht aus thermisch leitendem Material eine Dicke von kleiner oder gleich etwa 75 Mikrometer aufweist.

9. Bestückter flexibler elektronischer Träger nach wenigstens einem der vorhergehenden Ansprüche,
**dadurch gekennzeichnet, dass** das Versteifungselement (103; 305) und/oder die Schicht aus thermisch leitendem Material (201; 301) aus Kupfer ist/sind.

10. Bestückter flexibler elektronischer Träger nach wenigstens einem der vorhergehenden Ansprüche,
**dadurch gekennzeichnet, dass** die Leuchtdioden (101) vom Typ Leistungsleuchtdioden sind.

11. Bestückter flexibler elektronischer Träger nach wenigstens einem der vorhergehenden Ansprüche,
**dadurch gekennzeichnet, dass** er mehrere Leuchtdioden (101) und mehrere sich zwischen jeder Leuchtdiode erstreckende Verlängerungsbereiche umfasst.

12. Kraftfahrzeugscheinwerfer,
**dadurch gekennzeichnet, dass** er einen bestückten flexiblen elektronischen Träger nach einem der vorhergehenden Ansprüche umfasst.

13. Kraftfahrzeugscheinwerfer nach Anspruch 12,
**dadurch gekennzeichnet, dass** der bestückte flexible Träger eine dreidimensionale Anordnung mit mehreren Knickpunkten aufweist und dass der flexible Träger mehrere Leuchtdioden (101) umfasst, wobei die Knickpunkte zwischen bestimmten oder allen Leuchtdioden liegen.

## Claims

1. Equipped flexible electronic support (100; 300), of the equipped "flexboard" type, for a motor vehicle headlight, said equipped electronic support comprising:
- a flat flexible insulating support (202; 302) equipped on a first face (106; 306) with a plurality of flat conductive tracks (203; 303);
- at least one light source of the light emitting diode (101) type disposed on the first face of the flexible insulating support, and connected to at least one of the flat conductive tracks;
**characterised in that** a second face (107; 307) of the flexible insulating support is at least partially covered with a layer (201; 301) of thermally conductive material for dissipating the heat produced by said light emitting diode, said layer comprising a contact zone at the connection between said light emitting diode and said equipped flexible electronic support, and at least one extended zone extending out of this contact zone, said layer of thermally conductive material at least partially covering said second face of the flexible insulating support at the extended zone, the dissipation of the heat taking place mainly at this extended zone.

2. Equipped flexible electronic support according to claim 1, **characterised in that** each light emitting diode (101) disposed on the first face (106; 306) of the flexible insulating support is associated with a stiffening element (103; 305) disposed at the diode with which it is associated on the second face (107; 307) of the flexible insulating support.

3. Equipped flexible electronic support according to the preceding claim, **characterised in that** the stiffening element (103; 305) has at least one opening (500; 502) intended to receive a fixing pin (104), said fixing pin belonging to a three-dimensional optical part (102) on which the equipped flexible electronic support is placed.

4. Equipped flexible electronic support according to the preceding claim, **characterised in that** the opening of the stiffening element (103; 301) has a plurality of retention tongues (501; 503) for holding, after deformation, the fixing pin (104) that is intended for it.

5. Equipped flexible electronic support according to at least one of the preceding claims, **characterised in that** the layer of thermally conductive material covers the majority, preferentially the whole, of the second face of the flexible insulating support.

6. Equipped flexible electronic support according to at least one of the preceding claims, **characterised in that** the thickness and the material constituting the layer of thermally conductive material are chosen so that the layer of thermally conductive material is plastic.

7. Equipped flexible electronic support according to at least one of the preceding claims, **characterised in that** the layer of thermally conductive material has a thickness of less than 2 millimetres.

8. Equipped flexible electronic support according to at least one of the preceding claims, **characterised in that** the layer of thermally conductive material has a thickness of less than or equal to approximately 75 microns.

9. Equipped flexible electronic support according to at least one of the preceding claims, **characterised in that** the stiffening element (103; 305) and/or the layer of thermally conductive material (201; 301) is/are made from copper.

10. Equipped flexible electronic support according to at least one of the preceding claims, **characterised in that** the light emitting diodes (101) are of the power light emitting diode type.

11. Equipped flexible electronic support according to at least one of the preceding claims, **characterised in that** it comprises a plurality of light emitting diodes (101) and a plurality of extended zones extending between each light emitting diode.

12. Motor vehicle headlight, **characterised in that** it comprises an equipped flexible electronic support according to any of the preceding claims.

13. Motor vehicle headlight according to claim 12, **characterised in that** the equipped flexible support has a three-dimensional arrangement having a plurality of reversal points and **in that** the flexible support comprises a plurality of light emitting diodes (101), the reversal points being situated between some or all of the light emitting diodes.
